# EUROPEAN PATENT SPECIFICATION

(11) **EP 1 489 670 B1**
(45) Date of publication and mention of the grant of the patent: **16.01.2008**
(21) Application number: 03026608.4
(22) Date of filing: 19.11.2003
(51) Int. Cl.: H01L 45/00

(54) **Method for adjusting the threshold voltage of a memory cell**
Einstellverfahren für die Schwellenspannung einer Speicherzelle
Procédé pour ajuster la tension de seuil d'une cellule de mémoire

(30) Priority: 18.06.2003 US 465120
(43) Date of publication of application: 22.12.2004
(73) Proprietor: MACRONIX INTERNATIONAL CO., LTD., Hsinchu (TW)
(72) Inventor: Chen, Yi-Chou, Hsinchu (TW); Lu, Chih-Yuan, Hsinchu (TW)
(74) Representative: Becker Kurig Straus

(56) References cited:
- US-A- 3 530 441
- US-A- 4 199 692
- STEVENTON A G: "The switching mechanisms in amorphous chalcogenide memory devices" JOURNAL OF NON-CRYSTALLINE SOLIDS, AUG. 1976, NETHERLANDS, vol. 21, no. 3, pages 319-329, XP002278873 ISSN: 0022-3093

## Description

### BACKGROUND OF THE INVENTION

The present invention relates generally to memory devices and, more particularly, to a method for adjusting a threshold voltage of a memory cell.

Chalcogenide memory cells are nonvolatile and can change phases relatively quickly. Therefore, such memory cells have great potential to be the next generation memory. To date, developmental work regarding chalcogenide memory cells has focused on the ability of chalcogenide materials to change between an amorphous phase and a crystalline phase. In particular, developmental work for memory/solid state device applications has focused on the resistance of chalcogenide materials, and developmental work for optical applications has focused on the **n** and **k** changes of chalcogenide materials. For example, Figures 7 and 8 of U.S. Patent No. 3,530,441 show that the resistance of a chalcogenide material can be varied by applying energy to the material. At present, those skilled in the art consider the threshold voltage, Vₜₕ, of chalcogenide materials to be a "messy" property and, consequently, they have not focused on this property in developmental work for memory/solid state device applications or optical applications.

US 4,199,692 discloses an amorphous memory cell operated to have a first logic state represented by a high resistance state, substantially no crystal structure and a first threshold level and a second logic state represented by a high resistance state, microcrystal structure and a threshold level lower than the first threshold level.

### SUMMARY OF THE INVENTION

Broadly speaking, the present invention enables the threshold voltage, Vₜₕ, of a memory cell as well as the Vₜₕ of a chalcogenide material to be tuned or adjusted.

In accordance with one aspect of the present invention, a method for adjusting a threshold voltage of a chalcogenide film is provided. In this method, energy in form of a pulse is applied into a film comprised of a material capable of changing threshold voltage. The film may be included in a memory cell.

In one embodiment, the applying of energy includes applying an electrical pulse into the film. In one embodiment, the electrical pulse is a voltage pulse, and the voltage pulse has a predetermined magnitude, has a predetermined profile, and is applied for a predetermined duration. In one embodiment, the electrical pulse is a current pulse, and the current pulse has a predetermined magnitude, has a predetermined profile, and is applied for a predetermined duration.

In one embodiment, the applying of energy includes applying a pulse of light into the film. In one embodiment, the pulse of light is a laser pulse, and the laser pulse has a predetermined magnitude, has a predetermined profile, and is applied for a predetermined duration.

In one embodiment, the applying of energy includes applying a pulse of heat into the film. In one embodiment, the pulse of heat has a predetermined magnitude, has a predetermined profile, and is applied for a predetermined duration. In one embodiment, the applying of energy includes applying a pulse of microwave energy into the film. In one embodiment, the pulse of microwave energy has a predetermined magnitude, has a predetermined profile, and is applied for a predetermined duration.

It will be apparent to those skilled in the art that the method of adjusting the Vₜₕ of the present invention can be applied in numerous memory/solid state device applications. One of the significant advantages of the method of the present invention is the speed with which the Vₜₕ can be adjusted. After the application of the energy pulses, the quenching time is usually shorter than about 50 nanoseconds (ns). In contrast, it usually takes at least 100 ns to change the phase of a chalcogenide material.

It is to be understood that the foregoing general description and the following detailed description are exemplary and explanatory only and are not restrictive of the invention, as claimed.

### BRIEF DESCRIPTION OF THE DRAWINGS

The accompanying drawings, which are incorporated in and constitute part of this specification, illustrate exemplary embodiments of the invention and together with the description serve to explain the principles of the invention.
Figure 1 is an I-V curve of a chalcogenide memory cell.
Figure 2 is a graph of Vₜₕ versus pulse voltage at different pulse widths.
Figure 3 is a schematic diagram that illustrates the application of electrical pulses into a chalcogenide memory cell.
Figure 4 illustrates an exemplary duration (or profile) for a pulse of energy.
Figure 5 is a schematic diagram that illustrates the application of light pulses into a chalcogenide memory cell.
Figure 6 is a schematic diagram that illustrates the application of heat pulses into a chalcogenide memory cell.
Figure 7 is a cross-sectional view of a memory cell structure in which the method of adjusting the Vₜₕ of a material capable of changing Vₜₕ may be implemented.

### DETAILED DESCRIPTION OF EXEMPLARY EMBODIMENTS

Several exemplary embodiments of the invention will now be described in detail with reference to the accompanying drawings.

In accordance with the present invention, the threshold voltage, Vₜₕ, of a material capable of changing Vₜₕ is adjusted by applying energy into the material.

Materials capable of changing Vₜₕ include chalcogenide materials, particularly amorphous chalcogenide materials.

As used herein, the term "chalcogenide material" refers to an alloy containing at least one element from the Group 16 (old-style: Group VI) elements of the periodic table, i.e., O, S, Se, Te, and Po. Exemplary chalcogenide materials are disclosed in U.S. Patent No. 5,177,567 and the list of patents incorporated by reference in the '567 patent. This list includes U.S. Patent Nos. 3,271,591, 3,343,034, 3,571,669, 3,571,670, 3,571,671, 3,571,672, 3,588,638, 3,611,063, 3,619,732, 3,656,032, 3,846,767, 3,875,566, 3,886,577, and 3,980,505.

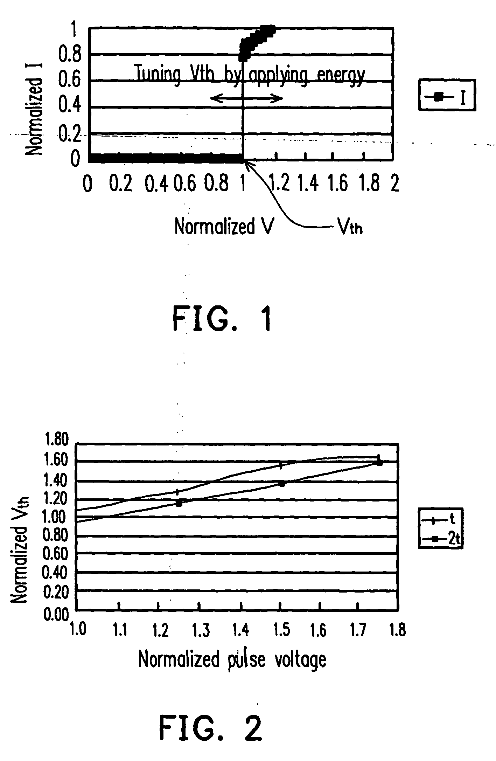

Figure 1 is an I-V curve of a chalcogenide memory cell. As shown in Figure 1, Vₜₕ occurs at a value of 1 volt (V) (normalized). Thus, when a voltage below Vₜₕ is applied to the cell, the current is very low. On the other hand, when a voltage above Vₜₕ is applied to the cell, the current jumps to a significantly higher level. As shown in Figure 1, the difference in the current for voltages above and below Vₜₕ is readily discernable. As will be explained in more detail below, the Vₜₕ of the cell may be adjusted either higher or lower (as indicated by the double-ended arrow in Figure 1) by applying energy into the chalcogenide film.

Figure 2 is a graph of Vₜₕ versus pulse voltage at different pulse widths. The pulse width for curve 100 (the top curve) was t, whereas the pulse width for curve 102 (the bottom curve) was 2t. Curves 100 and 102 demonstrate that the Vₜₕ of a chalcogenide memory cell can be adjusted by applying a certain voltage (or current) pulse with a certain pulse width (or profile) into the cell.

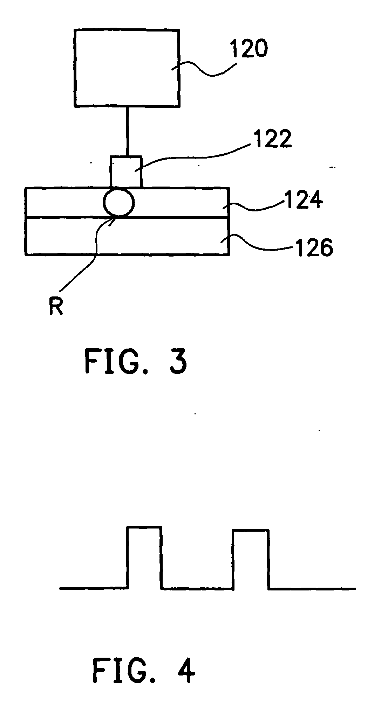

The energy may be applied into the material capable of changing Vₜₕ, e.g., a chalcogenide film in a memory cell, in any suitable form. By way of example, the energy may be applied in the form of electrical pulses, light pulses, microwave energy pulses, or heat pulses. Figure 3 is a schematic diagram that illustrates the application of electrical pulses into a chalcogenide memory cell. As shown in Figure 3, a voltage/current source 120 is coupled to top electrode 122 of the chalcogenide memory cell, which also includes chalcogenide film 124 and bottom electrode 126. When a voltage pulse (or current pulse) is applied into the cell, the portion of chalcogenide film 124 indicated by the arrow labeled R undergoes a change in Vₜₕ. An exemplary duration (or profile) for the voltage pulse (or current pulse) is shown in Figure 4.

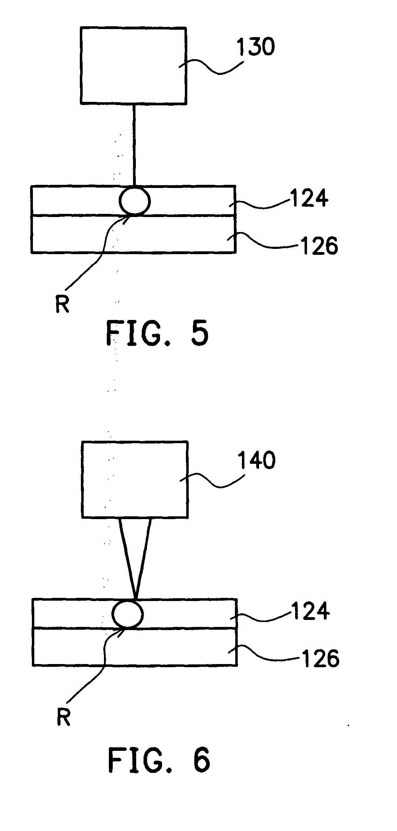

Figure 5 is a schematic diagram that illustrates the application of light pulses into a chalcogenide memory cell. As shown in Figure 5, light source 130 directs pulses of light into the cell. In one embodiment, the light pulses are laser pulses. When a light pulse, e.g., a laser pulse, is applied into the cell, the portion of chalcogenide film 124 indicated by the arrow labeled R undergoes a change in Vₜₕ. By way of example, the light pulses may have the duration (or profile) shown in Figure 4. Those skilled in the art will appreciate that the top electrode has been omitted from Figure 5, and that the top electrode may be provided above film 124 at a location that is offset from the region in which the light pulse is applied.

Figure 6 is a schematic diagram that illustrates the application of heat pulses into a chalcogenide memory cell. As shown in Figure 6, heat source 140 emits pulses of heat into the cell. In one embodiment, heat source 140 is a heated object. In another embodiment, heat source 140 is a microwave generator. When a pulse of heat, e.g., a pulse of heat from a heated object or a pulse of microwave energy, is applied into the cell, the portion of the chalcogenide film 124 indicated by the arrow labeled R undergoes a change in Vₜₕ. By way of example, the pulses of heat may have the duration (or profile) shown in Figure 4. Those skilled in the art will appreciate that the top electrode has been omitted from Figure 6, and that the top electrode may be provided above film 124 at a location that is offset from the region in which the pulse of heat is applied.

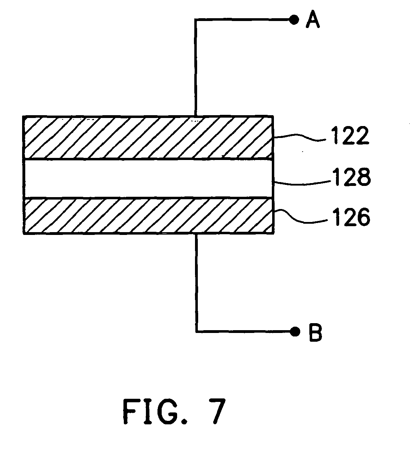

Figure 7 is a cross-sectional view of a memory cell structure in which the method of adjusting the Vₜₕ of a material capable of changing Vₜₕ may be implemented. As shown in Figure 7, the memory cell structure includes top electrode 122, a film 128 of a material capable of changing Vₜₕ, and bottom electrode 126. Top electrode 126 and bottom electrode 128 may be formed of any suitable conductive material, e.g., a metal, a metalloid, a semiconductor, e.g., silicon, an element, a compound, an alloy, or a composite. Film 128 is formed of a chalcogenide material.

In a memory cell array, electrical connections A and B to top electrode 122 and bottom electrode 126, respectively, are provided. By way of example, connection A may be to a bit line and connection B may be to a word line. Once the Vₜₕ of film 128 has been adjusted by applying energy in accordance with the method described herein, the state of the memory cell structure can be determined by checking the current flowing through the cell.

It will be apparent to those skilled in the art that the method of adjusting the Vₜₕ of the present invention can be applied in numerous memory/solid state device applications. One of the significant advantages of the method of the present invention is the speed with which the Vₜₕ can be adjusted. After the application of the energy pulses, the quenching time is usually shorter than about 50 nanoseconds (ns). In contrast, it usually takes at least 100 ns to change the phase of a chalcogenide material.

- In summary, the present invention provides a method for adjusting the Vₜₕ of a memory cell, and a method for adjusting the Vₜₕ of a chalcogenide material. The invention has been described herein in terms of several exemplary embodiments.

## Claims

1. A method for adjusting a threshold voltage of a chalcogenide film, comprising:
applying energy in form of a pulse with constant pulse width over a predetermined interval into the chalcogenide film such that the adjusted voltage of the chalcogenide film increases as a magnitude of the applied pulse height increases.

2. The method according to claim 1, wherein said chalcogenide film is included in a memory cell.

3. The method of claims 1 or 2, wherein the applying of energy comprises:
applying an electrical pulse into the film.

4. The method of claim 3, wherein the electrical pulse is a voltage pulse.

5. The method of claim 4, wherein the voltage pulse has a predetermined magnitude, has a predetermined profile, and is applied for a predetermined duration.

6. The method of claim 3, wherein the electrical pulse is a current pulse.

7. The method of claim 6, wherein the current pulse has a predetermined magnitude, has a predetermined profile, and is applied for a predetermined duration.

8. The method of claims 1 or 2, wherein the applying of energy comprises:
applying a pulse of light into the film.

9. The method of claim 8, wherein the pulse of light is a laser pulse.

10. The method of claim 9, wherein the laser pulse has a predetermined magnitude, has a predetermined profile, and is applied for a predetermined duration.

11. The method of claims 1 or 2, wherein the applying of energy comprises:
applying a pulse of heat into the film.

12. The method of claim 11, wherein the pulse of heat has a predetermined magnitude, has a predetermined profile, and is applied for a predetermined duration.

13. The method of claims 1 or 2, wherein the applying of energy comprises:
applying a pulse of microwave energy into the film.

14. The method of claim 13, wherein the pulse of microwave energy has a predetermined magnitude, has a predetermined profile, and is applied for a predetermined duration.

## Patentansprüche

1. Verfahren zum Einstellen einer Schwellwertspannung einer Chalkogenidschicht umfassend:
Zuführen einer Energie in Form eines Impulses mit konstanter Impulsbreite über ein vorher festgelegtes Intervall in die Chalkogenidschicht, so dass die eingestellte Spannung der Chalkogenidschicht zunimmt, wenn ein Betrag der zugeführten Impulshöhe zunimmt.

2. Verfahren gemäß Anspruch 1, wobei die Chalkogenidschicht in einer Speicherzelle enthalten ist.

3. Verfahren gemäß Anspruch 1 oder 2, wobei das Zuführen von Energie umfasst:
Zuführen eines elektrischen Impulses in die Schicht.

4. Verfahren gemäß Anspruch 3, wobei der elektrische Impulse ein Spannungsimpuls ist.

5. Verfahren gemäß Anspruch 4, wobei der Spannungsimpuls einen vorher festgelegten Betrag aufweist, ein vorher festgelegtes Profil aufweist und für eine vorher festgelegte Dauer zugeführt wird.

6. Verfahren gemäß Anspruch 3, wobei der elektrische Impuls ein Stromimpuls ist.

7. Verfahren gemäß Anspruch 6, wobei der Stromimpuls einen vorher festgelegten Betrag aufweist, ein vorher festgelegtes Profil aufweist und für eine vorher festgelegte Dauer zugeführt wird.

8. Verfahren gemäß Anspruch 1 oder 2, wobei das Zuführen von Energie umfasst:
Zuführen eines Lichtimpulses in die Schicht.

9. Verfahren gemäß Anspruch 8, wobei der Lichtimpuls ein Laserimpuls ist.

10. Verfahren gemäß Anspruch 9, wobei der Laserimpuls einen vorher festgelegten Betrag aufweist, ein vorher festgelegtes Profil aufweist und für eine vorher festgelegte Dauer zugeführt wird.

11. Verfahren gemäß Anspruch 1 oder 2, wobei das Zuführen von Energie umfasst:
Zuführen eines Hitzeimpulses in die Schicht.

12. Verfahren gemäß Anspruch 11, wobei der Hitzeimpuls einen vorher festgelegten Betrag aufweist, ein vorher festgelegtes Profil aufweist und für eine vorher festgelegte Dauer zugeführt wird.

13. Verfahren gemäß Anspruch 1 oder 2, wobei das Zuführen von Energie umfasst:
Zuführen eines Impulses von Mikrowellenenergie in die Schicht.

14. Verfahren gemäß Anspruch 13, wobei der Impuls von Mikrowellenenergie einen vorher festgelegten Betrag aufweist, ein vorher festgelegtes Profil aufweist und für eine vorher festgelegte Dauer zugeführt wird.

## Revendications

1. Procédé pour ajuster une tension de seuil d'une couche de chalcogénure, comprenant les étapes consistant à :
appliquer une énergie sous la forme d'une impulsion avec une largeur d'impulsion constante sur un intervalle de temps prédéterminé à l'intérieur d'une couche de chalcogénure de telle sorte que la tension ajustée de la couche de chalcogénure augmente à mesure qu'une grandeur de la hauteur de l'impulsion appliquée augmente.

2. Procédé selon la revendication 1, dans lequel ladite couche de chalcogénure est incluse dans une cellule de mémoire.

3. Procédé selon la revendication 1 ou 2, dans lequel l'application d'une énergie comprend l'étape consistant à :
appliquer une impulsion électrique à l'intérieur de la couche.

4. Procédé selon la revendication 3, dans lequel l'impulsion électrique est une impulsion de tension.

5. Procédé selon la revendication 4, dans lequel l'impulsion de tension a une grandeur prédéterminée, elle a un profil prédéterminé, et elle est appliquée pendant une période de temps prédéterminée.

6. Procédé selon la revendication 3, dans lequel l'impulsion électrique est une impulsion de courant.

7. Procédé selon la revendication 6, dans lequel l'impulsion de courant a une grandeur prédéterminée, elle a un profil prédéterminé, et elle est appliquée pendant une période de temps prédéterminée.

8. Procédé selon la revendication 1 ou 2, dans lequel l'application d'une énergie comprend l'étape consistant à :
appliquer une impulsion de lumière à l'intérieur de la couche.

9. Procédé selon la revendication 8, dans lequel l'impulsion de lumière est une impulsion laser.

10. Procédé selon la revendication 9, dans lequel l'impulsion laser a une grandeur prédéterminée, elle a un profil prédéterminé, et elle est appliquée pendant une période de temps prédéterminée.

11. Procédé selon la revendication 1 ou 2, dans lequel l'application d'une énergie comprend l'étape consistant à :
appliquer une impulsion de chaleur à l'intérieur de la couche.

12. Procédé selon la revendication 11, dans lequel l'impulsion de chaleur a une grandeur prédéterminée, elle a un profil prédéterminé, et elle est appliquée pendant une période de temps prédéterminée.

13. Procédé selon la revendication 1 ou 2, dans lequel l'application d'une énergie comprend l'étape consistant à :
appliquer une impulsion d'énergie à micro-ondes à l'intérieur de la couche.

14. Procédé selon la revendication 13, dans lequel l'impulsion d'énergie à micro-ondes a une grandeur prédéterminée, elle a un profil prédéterminé, et elle est appliquée pendant une période de temps prédéterminée.
